# EUROPÄISCHE PATENTSCHRIFT

(11) **EP 1 336 119 B1**
(45) Veröffentlichungstag und Bekanntmachung des Hinweises auf die Patenterteilung: **11.05.2011**
(21) Anmeldenummer: 01982484.6
(22) Anmeldetag: 13.11.2001
(51) Int. Cl.: G01S 13/88, G01F 23/284

(54) **DURCHFÜHRUNG FÜR EIN ELEKTRISCHES HOCHFREQUENZSIGNAL UND FÜLLSTANDMESSEINRICHTUNG MIT EINER SOLCHEN DURCHFÜHRUNG**
FEED-THROUGH FOR AN ELECTRIC HIGH FREQUENCY SIGNAL AND A LEVEL MEASURING DEVICE PROVIDED WITH SAID FEED-THROUGH
TRAVERSÉE POUR UN SIGNAL ELECTRIQUE HAUTE FREQUENCE, ET DISPOSITIF DE MESURE DE NIVEAU PRESENTANT UNE TELLE TRAVERSÉE

(30) Priorität: 23.11.2000 DE 10058026
(43) Veröffentlichungstag der Anmeldung: 20.08.2003
(73) Patentinhaber: VEGA Grieshaber KG, 77709 Wolfach (DE)
(72) Erfinder: GRIESSBAUM, Karl, 77796 Mühlenbach (DE); FEHRENBACH, Josef, 77716 Haslach i. K. (DE); MOTZER, Jürgen, 77723 Gengenbach (DE)
(74) Vertreter: Preuss, Udo
(86) Internationale Anmeldenummer: PCT/EP2001/013127
(87) Internationale Veröffentlichungsnummer: WO 2002/042793

(56) Entgegenhaltungen:
- EP-A- 0 773 433
- EP-A- 0 780 664
- EP-A- 0 928 955
- EP-A- 1 083 414
- WO-A-98/25109
- DE-A- 4 404 745
- US-A- 6 118 282

## Beschreibung

### Technisches Gebiet

Die Erfindung betrifft eine Durchführung für ein elektrisches Hochfrequenzsignal, wie es beispielsweise in einem Füllstandmessgerät erzeugt und nach Reflexion an einer zu überwachenden Oberfläche eines Füllgutes ausgewertet wird. Eine Durchführung dieser Art weist ein Leitelement auf, in das an einer Einleitstelle das elektrische Hochfrequenzsignal einzuspeisen ist und das an einer Ausleitstelle das elektrische Hochfrequenzsignal an eine Sonde überträgt. Ferner besitzt die Durchführung ein ein- oder mehrteiliges mechanisches Trägerelement. Zwischen dem Trägerelement und dem Leitelement ist eine ein- oder mehrteilige Isolierung vorhanden. Die Erfindung betrifft ferner nach dem Prinzip der Laufzeitmessung von geführten elektromagnetischen Wellen arbeitende Füllstandmesseinrichtungen, die mit einer Durchführung der vorgenannten Art ausgestattet sind.

### Stand der Technik

Zur Füllstandmessung werden Messsysteme eingesetzt, die aufgrund der gemessenen Laufzeit von elektromagnetischen Wellen eines in der Behälterdecke montierten Füllstandmessgeräts zur Füllgutoberfläche und zurück die Distanz zum Füllgut bestimmen. Aus der Kenntnis der Behälterhöhe kann dann die gesuchte Füllstandshöhe berechnet werden. Solche unter der Fachbezeichnung Füllstandradar bekannten Sensoren beruhen allesamt auf der Eigenschaft elektromagnetischer Wellen, sich innerhalb eines homogenen nichtleitenden Mediums mit konstanter Geschwindigkeit auszubreiten und an der Grenzfläche unterschiedlicher Medien zumindest teilweise reflektiert zu werden. Jede Grenzschicht zweier Medien mit unterschiedlichen Dielektrizitätskonstanten erzeugt bei Auftreffen der Welle ein Radarecho. Je größer der Unterschied der beiden Dielektrizitätskonstanten ist, desto stärker ändert sich der Wellenwiderstand der Wellenausbreitung und desto größer ist das zu beobachtende Echo.

Zur Bestimmung der gesuchten Wellenlaufzeit sind unterschiedliche Radarprinzipien bekannt. Die beiden hauptsächlich angewandten Verfahren sind zum einen das Impulslaufzeitverfahren (Pulsradar) und zum anderen das frequenzmodulierte Dauerstrichverfahren (FMCW-Radar). Das Pulsradar bedient sich der pulsförmigen Amplitudenmodulation der abzustrahlenden Welle und ermittelt die direkte Zeitdauer zwischen Aussendung und Empfang der Pulse. Das FMCW-Radar bestimmt die Laufzeit auf indirektem Weg über die Aussendung eines frequenzmodulierten Signals und Differenzbildung zwischen gesendeter und empfangener Momentanfrequenz.

Neben den unterschiedlichen Radarprinzipien werden auch je nach Anwendung verschiedene Frequenzbereiche der elektromagnetischen Wellen benutzt. So existieren beispielsweise Pulsradars mit Trägerfrequenzen im Bereich zwischen 5 und 30 GHz und daneben ebenso solche, die im Basisband als sogenannte Monopulsradars ohne Trägerfrequenz arbeiten.

Außerdem ist eine Reihe von Verfahren und Vorrichtungen bekannt, die elektromagnetische Welle auf die Füllgutoberfläche und zurück zu leiten. Dabei unterscheidet man grundsätzlich zwischen in den Raum abgestrahlter Welle und durch eine Leitung geführter Welle. Ein Füllstandmessgerät, bei dem Mikrowellen über eine Koaxialleitung in eine zur Abstrahlung einer elektromagnetischen Welle dienenden Antenne eingeleitet werden, ist aus der EP 0 834 722 A2 bekannt. Hier ist die Antenne zweiteilig ausgebildet. Ein Antennenteil in Form eines Vollzylinders besteht aus einem Dielektrikum und ist von einer metallenen Hülse umgeben. An dem einen Ende des Vollzylinders aus einem Dielektrikum wird die Mikrowelle eingeleitet, am anderen Ende erfolgt die Weitergabe an das abstrahlende Ende der Antenne. Die metallene Hülse erstreckt sich über den als Vollzylinder ausgebildeten Antennenbereich, der sich im Bereich eines Stutzens eines Behälters mit dem darin befindlichen Füllgut befindet. Dieser Antennenaufbau, insbesondere die Gestaltung im Stutzen des Behälters, bildet somit einen gefüllten Hohlleiter, um das Hochfrequenzsignal bzw. die Welle in den zur Abstrahlung dienenden Bereich der Antenne zu überführen. Dieser Aufbau bewirkt, dass die Antenne im Bereich der Messgerätebefestigung - also dem im Bereich des Stutzens liegenden Antennenteils - keine Mikrowellen sendet beziehungsweise in diesem Messgerätebefestigungsbereich keine reflektierten Mikrowellen empfängt. Zur Verhinderung eines Impedanzsprunges an demjenigen Ende der metallenen Hülse, das der abstrahlenden Antenne zugewandt ist, ist das Hülsenende abgeschrägt.

Aus der EP 0 922 942 A1 ist ebenfalls ein mit Mikrowellen arbeitendes Füllstandmessgerät mit abstrahlender Antenne bekannt. Hier wird die über ein Koaxialkabel zugeführte Mikrowelle in ein Endelement eingeführt, das antennenseitig mit einem Kegel ausgebildet ist. Daran schließt sich ein Einsatz aus einem Dielektrikum an, der eine dem Kegel entsprechende Ausnehmung des Endelements aufweist. Von diesem Einsatz aus Dielektrikum erfolgt dann eine Weiterleitung der Mikrowelle an die abstrahlenden Antennenteile. Zur Erzielung eines quasikontinuierlichen Übergangs ohne wesentlichen Impedanzsprung weist der Einsatz in antennenabgewandter Richtung einen höheren Anteil an Keramik auf als in einem in Senderichtung angeordneten, antennenzugewandten Abschnitt.

Einen bezüglich der Durchführung und Signalführung im Behälter, völlig anderen Aufbau aufweisende Radarsensoren, die die elektromagnetische Welle über eine Leitung (Sonde) zum Reflexionsort und zurückführen, werden auch als TDR (time domain reflektometrie)-Sensoren bezeichnet. Diese Sensoren besitzen gegenüber solchen, die hochfrequente Wellen frei abstrahlen, eine wesentlich geringere Dämpfung des reflektierten Echosignals, weil der Leistungsfluss nur in dem eng begrenzten Bereich in der Umgebung entlang des leitfähigen Wellenleiters erfolgt. Außerdem werden Störechos aus dem Behälterinneren, die z. B. von Reflexionen der Welle an Behältereinbauten (Rührwerke, Rohre) stammen und bei freistrahlenden Sensoren die Identifikation des einen Echos von der Füllgutoberfläche erschweren, bei den Sensoren mit geführten Wellen weitgehend vermieden. Dies führt dazu, dass die Füllstandmessung mit geführten elektromagnetischen Wellen weitgehend unabhängig von der Behälterkonstruktion und außerdem von den Produkteigenschaften des Füllguts oder sonstiger Betriebsbedingungen (z.B. Staub, Schüttgutwinkel) ist und deshalb zu sehr zuverlässigen Messergebnissen führt.

Als Wellenleiter zur Führung der Welle können alle hochfrequenzüblichen, bekannten Leitungen benutzt werden, bei denen die Welle zumindest teilweise das Medium durchdringt, das die metallischen Leiter umgibt oder von diesen umschlossen wird. Durch ihren einfachen mechanischen Aufbau und ihre Eignung für jegliche Füllgüter, d.h. Schüttgüter und Flüssigkeiten, wird besonders die Eindrahtleitung oder Einzelleitersonde in der Füllstandmesstechnik oft eingesetzt. In ihrer Ausgestaltung als Stab- oder Seilsonde ist sie vor allem unempfindlich gegen Ablagerungen und Anhaftungen von Füllgütern. In der DE 44 04 745 C2 ist ein Füllstandsensor mit einer solchen Sonde beispielhaft beschrieben.

Ein wichtiger Gesichtspunkt der TDR-Füllstandsensoren mit Einzelleitern ist die Einkopplung des Messsignals von der Elektronik auf die Sonde. Wichtig dabei ist, dass der Leitungsweg von der Elektronik (Elektronikeinheit) auf die Sonde keine größeren Impedanzsprünge für die geleitete Welle enthält. Denn an jeder sich sprunghaft ändernden Leitungsimpedanz wird ein Teil der Welle reflektiert. Dieser reflektierte Anteil ist zum einen nicht mehr für den Messzweck, der Reflexion an der Füllgutoberfläche, verfügbar, wodurch das dort erzeugte Echo an Amplitude verliert. Außerdem werden zusätzliche, störende Echos durch die Reflexion der Welle an eventuellen Leitungsimpedanzänderungen zwischen Elektronik und Sonde erzeugt, die die Identifikation der auszuwertenden Füllgutreflexion erschweren. Denn besonders das Störecho an der Stoßstelle zwischen Behälterdurchführung und Sonde erstreckt sich je nach benutzter Bandbreite des Messsignals über einen Entfernungsbereich direkt anschließend an die Stoßstelle. Bei kleinen Echos von der zu messenden Füllgutoberfläche und großem Störecho vom Impedanzsprung am Anfang der Sonde wird es unmöglich, Füllstände zu detektieren und genau zu vermessen, die das obere Ende der Sonde erreichen. Dadurch gibt es bei allen bekannten TDR-Sensoren mit Einzelleitersonde ein Mindestabstand zwischen Füllgut und Signaldurchführung durch die Behälterwandung, der nicht unterschritten werden sollte. Er liegt üblicherweise bei ca. 30cm.

Der Leitungsweg zwischen Elektronik und Sonde besteht bei Füllstandsensoren immer aus der erwähnten Durchführung und zusätzlich meist aus einem Koaxialkabel, welches die Verbindung zur Platine herstellt, auf der die elektronische Schaltung zur Erzeugung des Sendesignals und Auswertung des Reflexionssignals aufgebaut ist. Das Koaxialkabel kann in besonderen Fällen eingespart werden, wenn die Platine eine direkte elektrische und mechanische Verbindung zur Durchführung aufweist.

Die Durchführung dient dazu, das Messsignal vom außerhalb des Füllgutbehälters befestigten Sensor zur sich innerhalb des Behälters erstreckenden Sonde zu leiten. Außerdem muss sie einen mechanischen Halt für die Sonde bieten. Zu diesem Zweck besitzt sie üblicherweise ein metallenes Trägerelement, welches fest mit dem Behälter, z.B. in einer Deckelöffnung desselben, verbunden werden kann und ein die Welle leitendes Leitelement mechanisch stützt. Zur Vermeidung von Kurzschluss befindet sich zwischen Trägerelement und Leitelement ein Isolierelement. Das Leitelement verbindet einerseits das üblicherweise zur Elektronik führende Koaxialkabel und andererseits die im Behälter eingebaute Sonde.

Durchführungen für Einzelleitersonden sind üblicherweise koaxial aufgebaut, d.h. das Leitelement ist koaxial umgeben von Isolierelement und Trägerelement. Dieser grundsätzliche Aufbau kann nun auf verschiedenartige Weise technisch ausgestaltet werden, um bestimmten Anforderungen wie z.B. Abdichtung der Behälteratmosphäre, Druckfestigkeit, Aufnahme hoher Zugkräfte an der Sonde, hohe Temperatur und Beständigkeit gegen aggressive Behälteratmosphäre zu genügen. Neben den mechanischen Anforderungen an die Durchführung ist - wie schon erwähnt - die elektrische Anforderung einer Wellenführung ohne große Impedanzsprünge zu beachten. Diese Anforderung lässt sich für die koaxiale Leitung innerhalb der Durchführung erfüllen. Beispiele solcher Lösungen für gleichermaßen elektrisch und mechanisch geeignete Durchführungen finden sich in der EP 0773 433 A1, der EP 0780 664 A2 und der WO 98/25 109.

Die EP 0 928 955 A2 zeigt ein TDR-Füllstandsmessgerät mit einer Durchführung, deren elektrische Impedanz an einer Einleitstelle, an der ein elektrisches Hochfrequenzsignal einzuspeisen ist, der Impedanz der zur Einleitung des Hochfrequenzsignals dienenden Signalleitung angeglichen ist. Die Impedanz soll in der gesamten Durchführung bis zur Sonde hin nahezu konstant sein. Dadurch ergibt sich ein Impedanzsprung an der Ausleitstelle zur Sonder hin. Die US 6,118,282 zeigt ein der EP 0 928 955 A2 sehr ähnliches TDR-Füllstandsmessgerät, dessen Durchführung ebenfalls mit dem gleichen Problem behaftet ist. Alle dort beschriebenen Durchführungen geben Hinweise, wie die Leitungsimpedanz innerhalb der Durchführung weitgehend konstant zu halten ist. Für die Anpassung des unvermeidlichen Impedanzsprungs zwischen koaxialer Durchführung und der sich daran anschließenden Sonde (auch Einzelleiter genannt) finden sich in diesen Schriften keine Lösungen. Der angesprochene Impedanzsprung ist im Normalfall sehr ausgeprägt und dadurch besonders störend. Grund dafür ist die Tatsache, dass die Leitungsimpedanz eines Einzelleiters in der Größenordnung von 300Ω liegt. Bei koaxialen Leitungen ergibt sich die Impedanz aus dem Verhältnis der Durchmesser von Außenleiter D zu Innenleiter d sowie der Dielektrizitätskonstanten des dazwischenliegenden Isoliermaterials. Je größer das Verhältnis D/d und je kleiner die Dielektrizitätskonstante, desto größer wird die Impedanz. Das Maß D des Außenleiters wird in der Praxis nach oben begrenzt durch gebräuchliche Behälteröffnungen, das Maß d des Innenleiters wird nach unten begrenzt durch die erforderliche mechanische Stabilität des Leitelements. Insgesamt ist also die Leitungsimpedanz durch die vorgegebenen Begrenzungen der mechanischen Abmessungen zu höheren Werten hin eingeschränkt.

Einfach zu realisierende Impedanzwerte für koaxial aufgebaute Durchführungen liegen zwischen 50Ω und 100Ω und werden üblicherweise so bemessen, dass sie die Impedanz des Koaxialkabels, mit dem sie mit der Elektronik verbunden sind, weiterführen. Das bedeutet, dass die Impedanz der Koaxialdurchführung meist in der Nähe der Standardwerte 50Ω oder 75Ω liegt. Aus dieser Betrachtung resultiert ein Impedanzsprung an der Verbindungsstelle Durchführung- Einzelleiter um deutlich mehr als den Faktor 2. Die bisher bekannte Verbesserung der Leitungsanpassung von der Durchführungsimpedanz auf die Impedanz des Einzelleiters ist beispielsweise in der bereits erwähnten DE 44 04 745 C2 beschrieben. Durch einen sich an die Durchführung anschließenden Anpassungstrichter geht der Wellenwiderstand nicht sprunghaft sondern kontinuierlich über vom niedrigen Wert der Durchführung auf den hohen Wert der Einzelleitung. Nachteilig an dieser Lösung ist der erforderliche Platzbedarf des Trichters innerhalb des Behälters und die Gefahr von Füllgutanhaftungen innerhalb des Trichters sowie eventuelle schädigende Einflüsse der Behälteratmosphäre auf den Trichter.

In der nachveröffentlichten EP 1 083 414 A1 ist ein TDR-Füllstandsmessgerät zur Messung eines Füllstandes gezeigt, bei dem eine Durchführung einen Außen- und Innenleiter. Der Innenleiter weist zur Erhöhung des Wellenwiderstandes einen Leiterabschnitt mit einer von einer Zylinderform abweichenden Geometrie auf. Diese Geometrie soll dazu dienen, den Wellenwiderstand vor der hier als Wellenleiter bezeichneten Sonde eine Impedanzanpassung vorzuschalten, die in einem Frequenzbereich mit einer Bandbreite wirksam ist.

### Darstellung der Erfindung

Das der Erfindung zugrunde liegende technische Problem besteht darin, eine in Bezug auf störende Echos verbesserte Durchführung für Hochfrequenzsignale in einem TDR-Füllstandmessgerät bereitzustellen.

Dieses technische Problem wird durch eine Durchführung mit den Merkmalen des Anspruchs 1 gelöst. Eine erfindungsgemäße Durchführung der eingangs genannten Art zeichnet sich dadurch aus, dass mittels einem Dämpfungselement aus Dämpfung einer Welle, das im Bereich der Ausleitstelle vorhenden ist, die Impedanz der Durchführung und die Impedanz der zur führung und nicht zur Abstrahlung des Hochfrequenz-Signals dienenden Sonde an der Ausleitstelle erstmals im wesentlichen aneinander angeglichen sind. Im Gegensatz zum Stand der Technik wird also erstmals den Impedanzen an der Ausleitstelle der Durchführung Beachtung geschenkt und durch die Impedanzangleichung in diesem Bereich werden bisher auftretende Störreflexionen weitgehend verhindert bzw. zumindest reduziert.

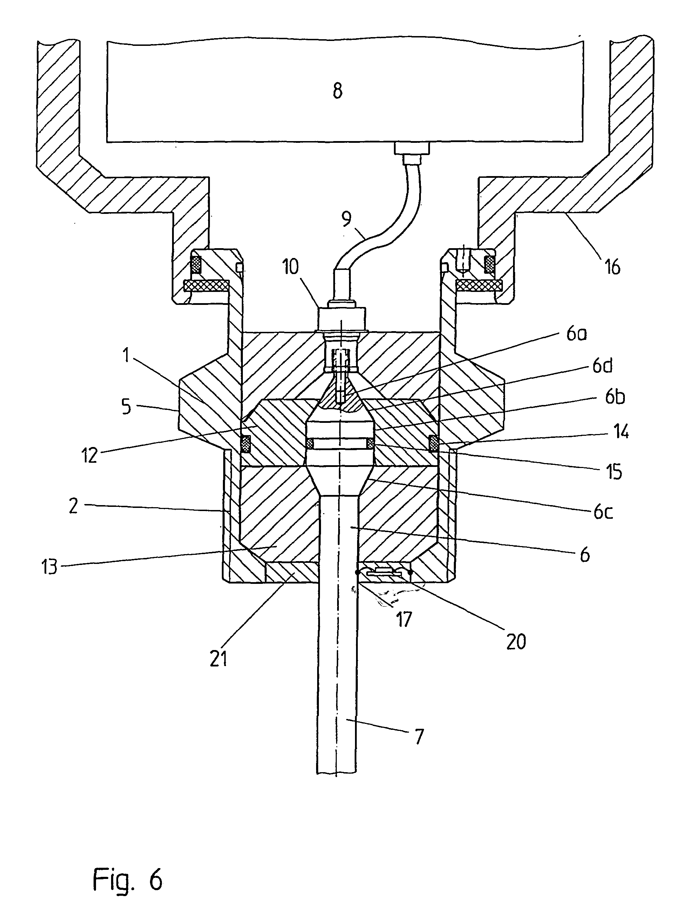

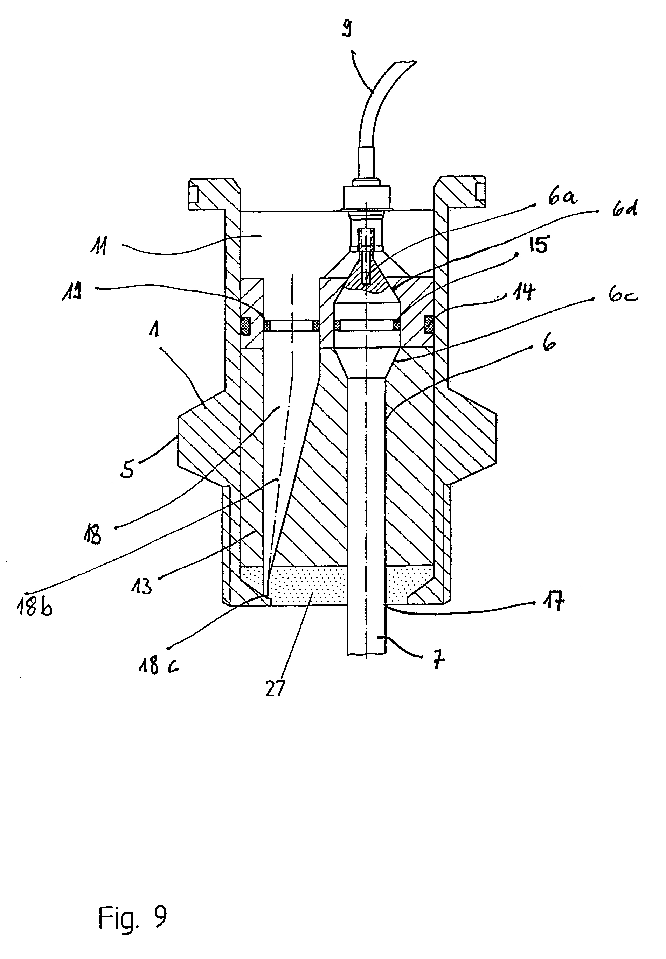

Es ist also möglich, die höhere Impedanz der Sonde auf die niedrigere Impedanz der Durchführung zu verringern. Dies wird durch Hinzufügung geeigneter Bauteile in der Nähe der Ausleitstelle erzielt, wie es z.B. in den Fig. 6-8 in verschieden Varianten gezeigt ist. Aus der Fig. 9 ist zudem ersichtlich, dass beide Lösungsprinzipien auch miteinander kombiniert werden können.

Eine Verbesserung gegenüber dem Stand der Technik ist bereits erzielt, wenn die Impedanz der Sonde nicht mehr als das 1,5-fache größer ist als die Impedanz der Durchführung an der Ausleitstelle, was im Sinne der Erfindung als eine im wesentlichen Angleichung der Impedanzen zu verstehen ist. D.h., dass beispielsweise unter zugrundelegen der zuvor genannten Bedingungen des Standes der Technik die Impedanz von 50Ω an der Einleitstelle bis auf eine Impedanz an der Ausleitstelle von 200Ω erhöht wird, so dass der Unterschied zur Impedanz der Sonde nur noch 100Ω beträgt, wodurch störende Reflexionen gegenüber dem Stand der Technik wesentlich verringert sind.

Der Erfindung liegt der Gedanke zugrunde, erstmals nicht wie im Stand der Technik durch raumeinnehmende, der Durchführung nachgeschaltete Einrichtungen einen unerwünschten Impedanzsprung zu verhindern, sondern in der Durchführung selbst für eine Impedanzangleichung am Übergang (Ausleitstelle) von der Durchführung zu der außerhalb der Durchführung liegenden Sonde zu sorgen. Dies kann durch eine passende Auswahl einzelner Bauteilmaterialien, eine neue Formgebung einzelner oder mehrerer Durchführungsbauteile oder auch durch einfach in die Durchführung zu integrierende, einen Impedanzanpassung bewirkende Elemente wie beispielsweise ein diskreter Widerstand, ein wellendämpfendes Element oder ein Hochfrequenz-Übertrager geleistet werden. Selbstverständlich sind auch Kombinationen zweier oder mehrerer der genannten Lösungsbeispiele möglich.

Eine Ausführungsform der Erfindung besteht darin, über eine Dämpfung der Welle innerhalb der Durchführung die Impedanzanpassung der beispielsweise koaxialen Leitung mit geringer Querschnittsfläche auf den in den Behälter ragenden Einzelleiter zu verbessern. Diese verlustbehaftete Anpassung, die prinzipiell bekannt ist, lässt sich für die Hochfrequenz-Durchführung entweder durch Einbau eines diskreten ohmschen Widerstandes oder durch Verwendung eines wellendämpfenden Materials als Leitungs-Dielektrikum verwirklichen. Als bevorzugtes Ausführungsbeispiel sei hier ein Material mit einer feinen Verteilung von Leitpigmenten innerhalb eines Füllmaterials genannt, wie beispielsweise feines Graphitpulver, welches einer Teflonmasse beigemischt wird. Durch das Volumen, die Form und die Leitfähigkeit des wellendämpfenden Materials lässt sich dabei die gewünschte Impedanzanpassung optimieren. Grundsätzlich beruht also dieses Lösungsprinzip auf einer ersten Parallelschaltung der Impedanz der Sonde und des ohmschen Widerstands bzw. des durch das wellendämpfende Material gebildeten Widerstandes. Diese erste Parallelschaltung ist wiederum mit der Impedanz der Koaxialleitung aus Leitelement und Trägerelement parallel geschaltet. Zusammenfassend ist eine Parallelschaltung aus der Impedanz der Sonde, dem diskreten ohmschen Widerstand bzw. dem wellendämpfenden Material und der Impedanz der Koaxialleitung im Bereich der Ausleitstelle geschaffen.

Die Wellendämpfung innerhalb der Durchführung bewirkt natürlich auch bei der auszuwertenden Füllgutreflexion eine Amplitudenverringerung, aber im Vergleich dazu wird das störende Echo an der Verbindungsstelle zwischen Durchführung und Einzelleiter stärker reduziert, so dass insgesamt ein günstigeres Verhältnis zwischen Nutzecho und Störecho erreicht wird. Dieses Verfahren der verlustbehafteten Anpassung lässt sich sowohl auf die aus dem Stand der Technik bekannten koaxialen Durchführungen als auch auf die zuvor beschriebene Durchführung mit Zweidrahtleitung in vorteilhafter Weise anwenden.

Eine weitere Ausführungsform besteht darin, mittels eines Hochfrequenz-Übertragers die relativ niedrige Impedanz der Wellenleitung innerhalb der Durchführung und die relativ hohe Impedanz der Einzelleitersonde aneinander anzupassen. Prinzipiell ist eine solche Impedanztransformation mit Hilfe eines Übertragers bekannt. Die Impedanz ändert sich vom Ein- zum Ausgang des Übertragers quadratisch zum Spannungsübertragungsverhältnis bzw. Windungsverhältnis. Allerdings muß im Falle der zu optimierenden Durchführung der Übertrager an der Stelle des bestehenden Impedanzsprungs, d.h. am Übergang der Durchführung auf den Einzelleiter eingebaut sein. Eine Lösung hierfür ist, den Einzelleiter isoliert in der Durchführung zu haltern und in der Nähe des Endes der Durchführung den Übertrager mit dem Beginn des metallischen Einzelleiters zu verbinden. Durch Veränderung des Windungsverhältnisses des Übertragers kann eine Anpassung verschiedener, theoretisch beliebiger Ein- und Ausgangsimpedanzen erreicht werden.

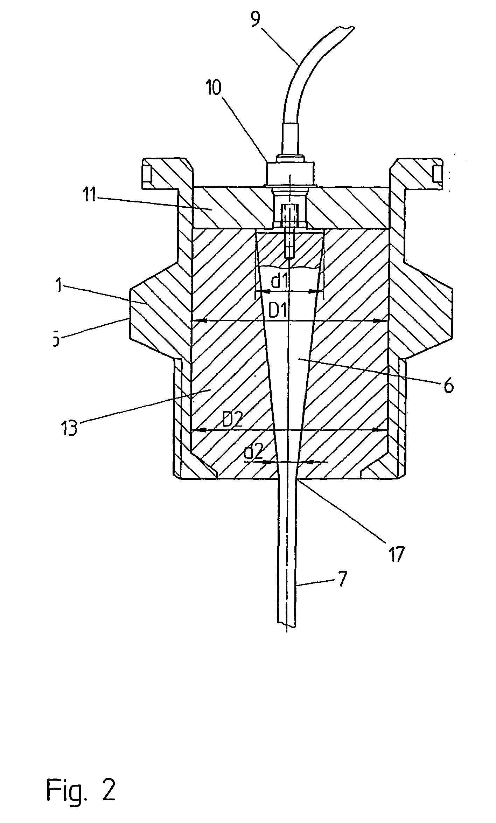

Bei dieser Ausführungsform wird der Impedanzsprung mit den damit verbundenen Nachteilen durch den Hochfrequenz-Übertrager sozusagen "verhindert". Im Gegensatz zu der Ausführungsform gemäß der Fig. 2, bei der die Anpassung der Impedanzen an der Ausleitstelle dadurch erzielt wird, dass die Impedanz innerhalb der Durchführung zur Ausleitstelle hin wesentlich erhöht wird, und zwar in Richtung auf die höhere Impedanz der Sonde, muß hier die Impedanz innerhalb der Durchführung nicht wesentlich verändert werden. An der Ausleitstelle wird nun durch den Hochfrequenz-Übertrager eine gegenseitige Impedanzangleichung "erzwungen".

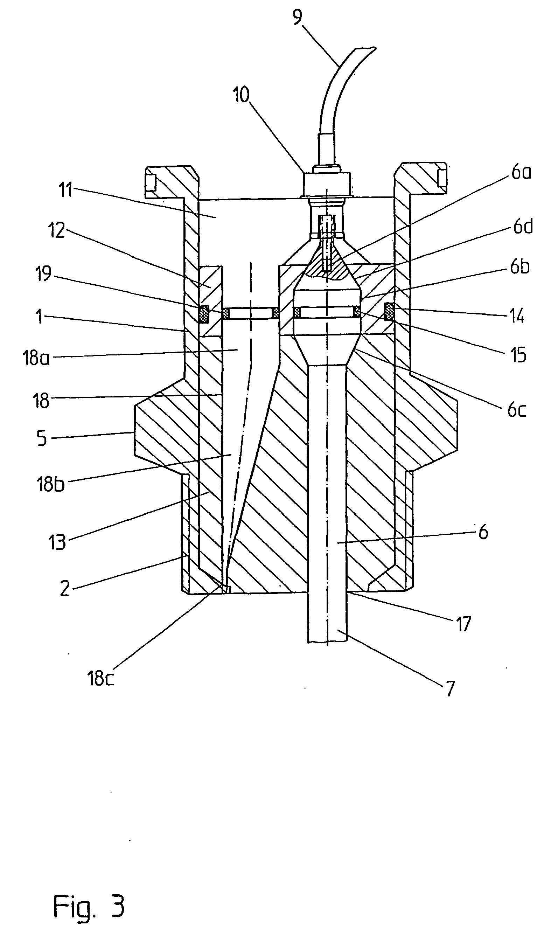

Es sei hier nach erwähnt, dass die vorherigen Ansführungsformen der Erfindung auch mit nachfolgenellen Maßnahmen kombiniert werden können so kann man zusätzliche unterschiedliche bauliche Maßnahmen die Impedanz innerhalb der Durchführung auf die höhere Impedanz der Sonde erhöhen. Derartige Ausführungsformen umfassen beispielsweise Abmessungsveränderungen verschiedener Bauteile innerhalb der Durchführung (siehe z.B. Fig. 2 und 3).

Eine ausätzeiche Maßnahme zur Erzielung einer Imperlauzaupassung an der Austertstelle kann vorgorelsweise darin bestehen, bei einer koaxial aufgebauten Durchführung durch kontinuierliche Veränderung der Impedanz der Leitung eine Anpassung zwischen der Impedanz der Verbindung zur Elektronik und der Impedanz der Sonde herzustellen. Dies ist beispielsweise realisierbar durch kontinuierliche Veränderung des Verhältnisses von Innendurchmesser des Trägerelements zum Durchmesser des Leitelements, jeweils bezogen auf eine Schnittebene senkrecht zur Wellenausbreitungsrichtung. So ist z.B. eine kontinuierliche Impedanzveränderung von 50Ω auf 300Ω möglich. Je länger die Zone der kontinuierlichen Impedanzveränderung gebaut werden kann, desto reflexionsärmer wirkt sie. Im Idealfall wird die Welle ohne größere Reflexion von einem Ende der Durchführung zum anderen geleitet und findet auch an der Verbindungsstelle zur Sonde keine größere Impedanzveränderung vor. Die kontinuierlich oder alternativ auch in mehreren Stufen realisierte Durclunesserverhältnisänderung kann durch kegelige Form des Leitelements, durch konische Innenkontur des Trägerelements oder eine Kombination dieser beiden Möglichkeiten erreicht werden.

Bei gefordertem Mindestdurchmesser des Leitelements und behälterbedingt begrenztem Außendurchmesser des Trägerelements ist diese Lösung jedoch nur bedingt anwendbar, da in diesem Fall nicht beliebig hohe Impedanzen innerhalb der Durchführung realisierbar sind.

Eine weitere ausätzliche Maßnahme zur Erzichtung einer Impedanzanpassung ohne die zuvor genannte Einschränkung kann darin bestehen, die Durchführung nicht rein koaxial aufzubauen, sondern innerhalb des metallenen Trägerelements eine sogenannte Zweidrahtleitung zu realisieren. Durch kontinuierliche Veränderung der Dicke und des Abstands des zusätzlichen zweiten Leitelementes sowie durch Begrenzung der Länge des zweiten Leitelementes auf die Baulänge der Durchführung kann eine kontinuierliche Impedanzerhöhung der Leitung trotz begrenzter Querschnittsfläche erreicht werden. In den Behälter ragt bei dieser Konstruktion weiterhin nur die Sonde mit allen bekannten Vorteilen dieser einfachen Sonde. Die Impedanz einer Zweidrahtleitung kann insbesondere dann, wenn sie unsymmetrisch aufgebaut ist ( d.h. die Drahtdurchmesser unterschiedlich sind), auf geringer ausgenutzter Querschnittsfläche relativ hoch, beispielsweise ca. 250Ω, realisiert werden. Ebenso sind aber auch ohne weiteres auf gleicher begrenzter Querschnittsfläche Impedanzen < 100Ω mit der Zweidrahtleitung möglich.

### Kurze Beschreibung der Zeichnungen

Im folgenden sind zur weiteren Erläuterung und zum besseren Verständnis mehrere Ausführungsformen der Erfindung unter Bezugnahme auf die beigefügten Zeichnungen näher beschrieben und erläutert. Es zeigt:
- Fig. 1: eine Hochfrequenz-Durchführung für eine Einzelleiter-Füllstandsonde nach dem Stand der Technik,
- Fig. 2: eine Hochfrequenz-Durchführung für eine Einzelleiter-Füllstandsonde mit koaxialer Leitung mit sich verändernden Durchmesserverhältnis zwischen Außen- und Innenleiter,
- Fig. 3: eine Hochfrequenz-Durchführung für eine Einzelleiter-Füllstandsonde mit auf die Durchführung begrenzter Zweidrahtleitung,
- Fig. 4: ein Schema einer verlustbehafteten Anpassung,
- Fig. 5: ein beispielhaftes Diagramm zur Bestimmung von Nutz- und Störechoamplitude bei verlustbehafteter Impedanzanpassung nach dem Schema von Fig. 4,
- Fig. 6: eine Ausführungsform einer erfindungsgemäßen Hochfrequenz-Durchführung für eine Einzelleiter-Füllstandsonde mit verlustbehafteter Impedanzanpassung mittels eines diskreten Widerstands,
- Fig. 7: eine weitere Ausführungsform einer erfindungsgemäßen Hochfrequenz-Durchführung für eine Einzelleiter-Füllstandsonde mit verlustbehafteter Impedanzanpassung mittels eines wellendämpfenden Materials,
- Fig. 8: eine weitere Ausführungsform einer Hochfrequenz-Durchführung für eine Einzelleiter-Füllstandsonde mit einem Hochfrequenz-Übertrager zur Impedanzanpassung,
- Fig. 9: eine weitere Ausführungsform einer erfindungsgemäßen Hochfrequenz-Durchführung für eine Einzelleiter-Füllstandsonde, in der zwei zuvor beschriebene Lösungsvarianten miteinander kombiniert sind.

### Beschreibung bevorzugter Ausführungsformen der Erfindung

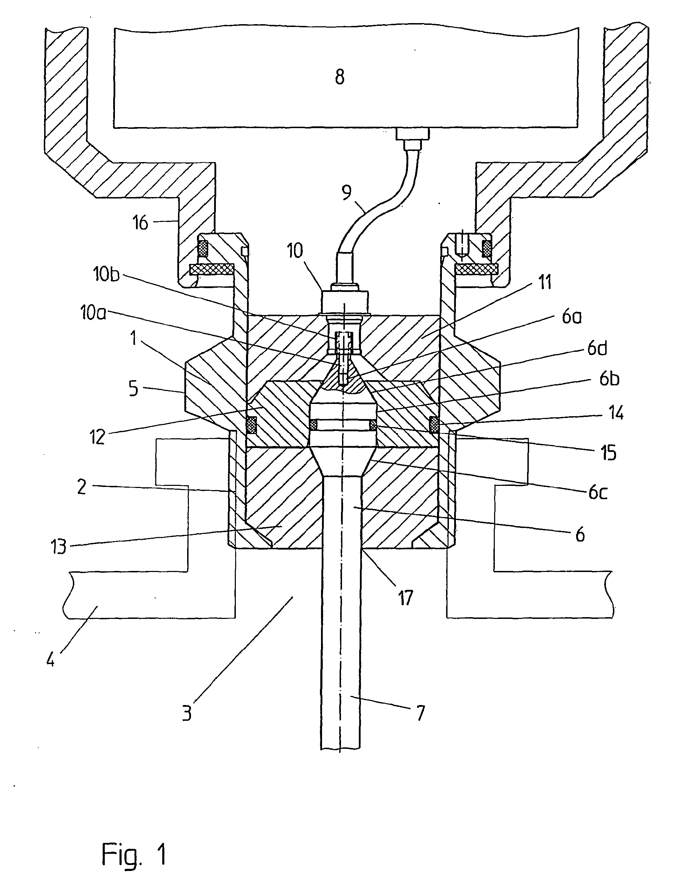

Die in Fig. 1 dargestellte Hochfrequenz-Durchführung gemäß dem Stand der Technik weist ein Trägerelement 1 auf, das üblicherweise aus Metall hergestellt und über ein in dessen Unterteil angebrachten Außengewinde 2 in einer Öffnung 3 der Behälterdecke 4 mit entsprechendem Innengewinde einschraubbar ist. Zur Montage besitzt das Trägerelement 1 einen Außensechskant 5. Koaxial zum Trägerelement 1 besitzt die Durchführung ein ebenfalls metallenes Leitelement 6. Es verbindet die in den Behälter ragende Einzelleitersonde 7 mit dem Steckanschluss 10, der seinerseits über das Koaxialkabel 9 mit der Elektronikeinheit 8 verbunden ist. Der Steckanschluss 10 besitzt einen federnden Stift 10a, der von einer Bohrung 6a am einen Ende des Leitelements 6 kontaktierend aufgenommen wird. Der Außenmantel 10b des Steckanschlusses 10 kontaktiert über nicht näher dargestellte Federn die Metallscheibe 11, die ihrerseits mechanisch und elektrisch fest mit dem Trägerelement 1 verbunden ist. Durch entsprechende Auswahl und Dimensionierung der verschiedenen mechanischen Elemente der Durchführung kann man erreichen, dass die Leitungsimpedanz der Koaxialleitung 9 angepasst fortgeführt wird vom koaxialen Leitungsaufbau der Durchführung, die im wesentlichen aus Trägerelement 1 und Leitelement 6 besteht.

Zur gegenseitigen Isolation und mechanischen Fixierung wird der Zwischenraum zwischen dem Leitelement 6 und dem Trägerelement 1 weitgehend ausgefüllt von nichtleitenden Isolationselementen 12 und 13. Das Leitelement 6 besitzt zur Aufnahme von Druck- und Zugkräften an der Sonde 7 eine Verdickung 6b mit daran anschließenden konischen Abschnitten 6c und 6d. Diese übertragen die vom Behälter her wirkenden Kräfte auf die Isolationselemente 12 und 13, welche ihrerseits wieder durch das Trägerelement 1 und die Metallscheibe 11 gestützt werden. Dichtringe 14 und 15 sorgen dafür, dass Gase aus dem Behälterinneren nicht durch die Durchführung nach außen dringen können. An ihrem oberen Ende ist die Durchführung verbunden mit dem Elektronikgehäuse 16, welches hier nur teilweise angedeutet ist.

In der Elektronikeinheit 8 wird ein beispielsweise pulsförmiges Sendesignal erzeugt, welches geleitet über das Koaxialkabel 9, den Steckanschluss 10 und die koaxiale Durchführung auf die Einzelleitersonde 7 gelangt. An der Verbindungsstelle 17 zwischen Leitelement 6 und Sonde 7 verändert sich für diese Konstruktion unvermeidlich die Leitungsimpedanz relativ sprunghaft. Ausgehend davon, dass die Impedanz der Koaxialleitung üblicherweise bei 50Ω liegt und die koaxiale Durchführung diese Impedanz weitgehend beibehält, ergibt sich an der Verbindungs- oder Ausleitstelle 17 ein Impedanzsprung von diesen ca. 50Ω auf ca. 300Ω. Dadurch bedingt wird ein Großteil des Sendesignals an dieser Stelle zur Elektronik 8 zurückreflektiert. Der restliche Anteil der Welle läuft die Sonde 7 entlang bis zur Füllgutoberfläche. Dort wird je nach Dielektrizitätskonstante des Füllguts ein weiterer Teil der Welle reflektiert. Der jetzt noch übrige Teil dringt ins Füllgut ein und wird am Sondenende reflektiert bzw. teilweise durch dämpfende Eigenschaft des Füllguts absorbiert. Die zurückreflektierten Echos von der Verbindungsstelle 17, der Füllgutoberfläche und eventuell des Sondenendes werden in der Elektronikeinheit 8 empfangen, verarbeitet und ausgewertet, wie aus dem Stand der Technik hinlänglich bekannt ist. Da das Störecho von der Verbindungsstelle 17 deutlich größer sein kann als das Nutzecho von der Füllgutoberfläche, lässt sich letzteres nicht mehr eindeutig identifizieren und auswerten, wenn der Füllstand in die Nähe der Verbindungsstelle 17 kommt.

Eine Verbesserung dieses einzuhaltenden Mindestabstandes lässt sich durch eine Durchführung, wie sie in der Fig. 2 dargestellt ist, erreichen. In der Fig. 2 sind Bauteile, die denen von der Fig. 1 entsprechen, mit gleichen Bezugszeichen gekennzeichnet. Das Leitelement 6 hat hier einen sich kontinuierlich verringernden Durchmesser d, während der Innendurchmesser D des Trägerelements 1 weitgehend konstant bleibt. Die dadurch gebildete Koaxialleitung kann dadurch so ausgeführt werden, dass sie im Anschluss an den Anschlussstecker 10 eine im wesentlichen gleiche Impedanz besitzt wie eben dieser Anschlussstecker 10 und die Zuleitung 9. Möglich wird dies bei geeigneter Wahl des Durchmesserverhältnisses D1/d1 unter gleichzeitiger Beachtung der Dielektrizitätskonstanten des Isolationselements 13.

In der Nähe der Verbindungsstelle 17 hat sich das Durchmesserverhältnis D2/d2 so verändert, dass die daraus resultierende Impedanz der Koaxialleitung sich der Impedanz des Einzelleiters 7 weiter angenähert hat bzw. dieser gleicht. Das Resultat dieser Anpassung ist eine Verminderung der Störreflexion von der Verbindungsstelle 17 und eine gleichzeitige Amplitudenerhöhung der Reflexion vom Füllgut, das den Einzelleiter umgibt. Diese kontinuierliche Impedanzanpassung mittels der Koaxialleitung innerhalb der Durchführung kann im Bedarfsfall auch durch mehrere gestufte Impedanzveränderungen ersetzt werden. Je feiner die Stufung ist, desto reflexionsfreier wirkt die Anpassung. Anstatt den Durchmesser d des Leitelements 6 zu verändern, kann auch der Innendurchmesser D des Trägerelements 1 oder beide zusammen entsprechend geändert werden. Ebenso ist es möglich, bei konstantem Durchmesserverhältnis D/d die Dielektrizitätskonstante des Isolierelements 13 kontinuierlich oder gestuft so zu verändern, dass die Impedanz der Koaxialleitung variiert wird.

Ein zweite Durchführung ist in der Fig. 3 dargestellt. Das Leitelement 6 sitzt hier nicht mehr zentrisch innerhalb des Trägerelements 1, sondern aus der Mitte versetzt, so dass daneben ein zweites Leitelement 18 untergebracht werden kann. Dieses zweite metallene Leitelement 18 ist mechanisch und elektrisch verbunden mit der Metallscheibe 11 und erhält damit eine leitende Verbindung mit dem Außenleiter des Koaxialkabels 9. Es besitzt einen zylindrischen Abschnitt 18a, abgedichtet über einen Dichtring 19, und einen kegeligen Abschnitt 18b, der in einer Spitze 18c endet. Zusammen mit dem Leitelement 6 bildet es eine Zweidraht- bzw. Paralleldrahtleitung. Abstand und Durchmesser des Abschnitts 18b verändern sich dabei relativ zum Leitelement 6 kontinuierlich. Die dadurch gebildete unsymmetrische Zweidrahtleitung leitet die Welle durch die Durchführung. Ihre Impedanz wird bestimmt durch gegenseitigen Abstand und Durchmesser der beiden Leiter. Je stärker die Unsymmetrie und je größer der gegenseitige Abstand, um so größer die Impedanz. Durch geeignete Wahl von Abstand und Durchmesserverlauf des zweiten Leitelements 18 kann eine kontinuierliche Impedanzveränderung der Paralleldrahtleitung von Werten < 100Ω bis auf Werte > 300Ω realisiert werden. Damit lässt sich der Impedanzsprung an der Verbindungsstelle 17 deutlich vermindern, wodurch sich die Amplitude des zugehörigen Störechos reduziert und insgesamt ein geringerer Mindestabstand des Füllguts zur Durchführung realisierbar ist.

Damit das Ende der Zweidrahtleitung bzw. das Ende des zweiten Leitelements 18c nicht ein zusätzliches Störecho erzeugt, kann es wie in Fig. 2 dargestellt mit dem Trägerelement 1 kurzgeschlossen werden. Durch unterschiedliche Echopolarität des Echos von diesem Kurzschluss und eines eventuell verbliebenen reflektierten Anteils der Welle an der Verbindungsstelle 17, die durch den Übergang von niedriger Impedanz zu hoher Impedanz mehr in der Nähe des elektrischen Leerlaufs liegt, können sich diese beiden Anteile gegenseitig kompensieren und damit das resultierende Störecho weiter reduzieren.

Alternativ zum Kurzschluss des Endes 18c kann dieses auch durch eine ohmsche Anbindung an das Trägerelement 1 elektrisch wellenabsorbierend ausgestaltet werden, damit keine zusätzliche Reflexion der Welle entsteht. Beispiel einer solchen ohmschen Anbindung ist ein induktivitätsarmer SMD-Widerstand in der Größenordnung von 200 bis 500Ω.

Falls es nicht ganz gelingt, den dem Behälter abgewandten Teil der Paralleldrahtleitung innerhalb der Durchführung durch Festlegung der Geometrie in seiner Impedanz so einzurichten, dass diese mit der des Koaxialkabels 9 und Steckanschlusses 10 relativ gut übereinstimmt, kann direkt nach dem Steckanschluss 10 ein hochfrequenztauglicher Übertrager eingebaut werden. Dieser transformiert das über das koaxiale System aus Kabel und Steckanschluss ankommende Signal auf das Zweidrahtsystem, bestehend aus den beiden Leitelementen 6 und 18. Die Spannungstransformation bedeutet gleichzeitig auch eine Impedanztransformation und ergibt damit die Möglichkeit einer Anpassung verschiedener Leitungsimpedanzen. Geeignete Übertrager mit spezieller Bauform und geeignetem Ferritmaterial sind handelsüblich. Der entsprechende Schaltungsaufbau ist dem Fachmann geläufig, weshalb an dieser Stelle nicht weiter darauf eingegangen wird.

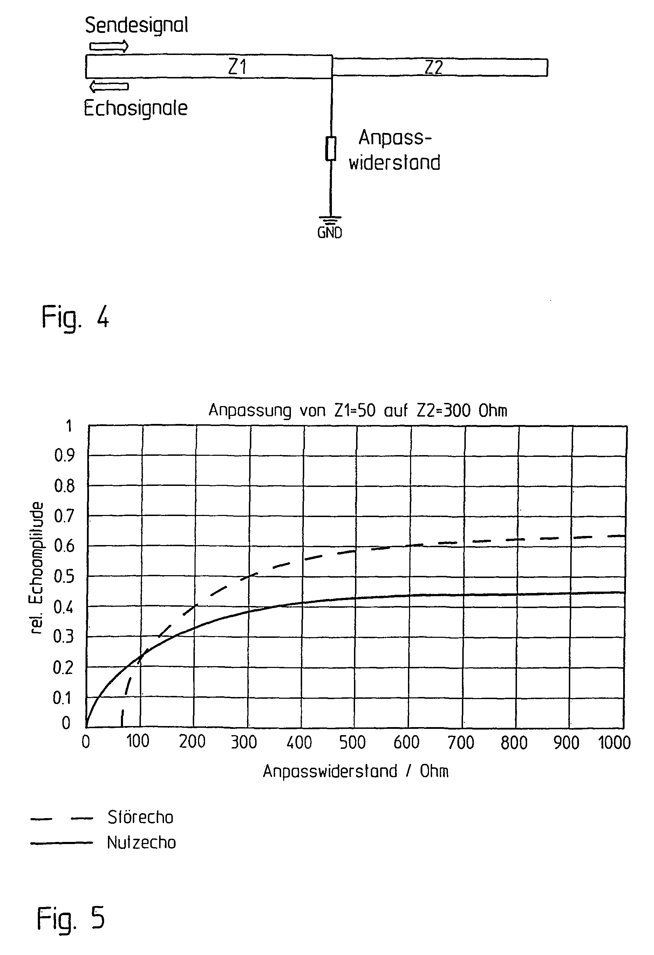

Ein erfindungsgemäßer Lösungsansatz zur Verbesserung der Impedanzanpassung zwischen Durchführung und Einzelleitersonde liegt wie erwähnt in der Parallelschaltung eines verlustbehafteten bzw. wellendämpfenden Bauelements. Diese grundsätzliche Methode ist dem Fachmann bekannt. In Fig. 4 ist ein Beispiel gezeigt, bei dem eine erste Leitung mit dem Wellenwiderstand Z1 verbunden ist mit einer zweiten Leitung mit dem in diesem Fall höheren Wellenwiderstand Z2. Der an der Verbindungsstelle entstandene Impedanzsprung kann durch die Parallelschaltung des Anpasswiderstandes verringert bzw. ganz vermieden werden. Für das über die erste Leitung ankommende Sendesignal ergibt sich an der Verbindungsstelle eine Impedanz, die sich aus der Parallelschaltung von Leitungsimpedanz Z2 und Anpasswiderstand errechnet. Damit ist ideale Impedanzanpassung realisierbar, allerdings verbunden mit einem Verlust an Signalamplitude des auf der zweiten Leitung weiterlaufenden Sendesignals. Mit anderen Worten bewirkt diese Art der Anpassung eine deutliche Verringerung oder komplette Vermeidung des Störechos von der Verbindungsstelle auf Kosten der Amplitude des auf dem weiteren Signalweg erzeugten Nutzechos von der Füllgutoberfläche.

In Fig. 5 ist in einem Diagramm für das Beispiel einer ersten Leitung mit Z1=50Ω und einer zweiten Leitung mit Z2=300Ω dargestellt, wie sich die Amplituden von Nutz- und Störecho bei verschiedenen Anpasswiderständen verändern. Die Amplituden sind dargestellt relativ zur Sendesignalamplitude. Das Störecho bezeichnet die Reflexion von der Verbindungsstelle der beiden Leitungen, das Nutzecho bezeichnet in diesem Fall die Totalreflexion der Welle am Ende der zweiten Leitung. Aus dem Diagramm geht hervor, dass mit kleiner werdendem Anpasswiderstand die Amplitude des Störechos schneller abnimmt als die des Nutzechos. Im gezeigten Beispiel wird das Störecho beim Anpasswiderstand 60Ω vollständig eliminiert, während das Nutzecho noch eine relative Amplitude von 0,17 besitzt. Bei ausreichend zur Verfügung stehender Sendesignalamplitude ergeben sich trotz Verlust genügend große Nutzechos, während das Verhältnis von Nutzecho zu Störecho deutlich verbessert wird.

In der Fig. 6 ist dargestellt, wie die Methode der verlustbehafteten Anpassung auf die Durchführung nach dem Stand der Technik aus Fig. 1 angewendet werden kann. Es sind einander entsprechende Bauteile wieder mit den gleichen Bezugszeichen wie in Fig. 1 gekennzeichnet. Zusätzlich zum Stand der Technik ist bei der erfindungsgemäßen Durchführung nach der Fig. 6 in der Nähe der Verbindungsstelle 17 ein Anpasswiderstand 20 eingebaut. Das kann beispielsweise ein auf einer Platine aufgelöteter induktivitätsarmer SMD-Widerstand sein, der über kurze Leitungen einerseits mit dem Leitelement 6 und andererseits mit dem Trägerelement 1 verbunden ist. Zum Schutz des Widerstands 20 vor Einflüssen der Behälteratmosphäre ist er eingegossen in eine Schutzschicht 21. Der Wert des Anpasswiderstands kann nach den Gesichtspunkten gewählt werden, welches Verhältnis zwischen Störecho und Nutzecho angestrebt wird und wie viel Verringerung an Nutzechoamplitude man sich gleichzeitig erlauben kann. Die grundsätzlichen Zusammenhänge wurden in Verbindung mit dem Diagramm aus Fig. 5 bereits beschrieben. An Stelle der kurzen Leitungen ist in vorteilhafter Weise eine flexible Kontaktierung zwischen Platine und Trägerelement bzw. Leitelement möglich. Dazu ist die Platine beispielsweise kreisringförmig ausgebildet und konzentrisch zum Leitelement eingebaut. Sie besitzt an ihrem äußeren und inneren Rand jeweils eine ebenfalls ringförmige Leiterbahn. Der aufgelötete SMD-Widerstand ist mit seinem einen Kontakt mit der äußeren, mit seinem anderen Kontakt mit der inneren ringförmigen Leiterbahn verbunden. Die Kontaktierungen geschehen beispielsweise über eine erste ringförmige Spiralfeder, die auf der äußeren Leiterbahn aufliegt und gleichzeitig die Innenwand des Trägerelements rundum berührt, und durch eine zweite ringförmige Spiralfeder, die auf der inneren Leiterbahn aufliegt und gleichzeitig die Außenwand des Leitelements rundum berührt. Diese Art der Kontaktierung erlaubt gewisse gegenseitige Verschiebungen der zu kontaktierenden Teile, beispielsweise durch Temperaturausdehnungen der Materialien. Anstelle eines einzigen SMD-Widerstands können auch zwei oder mehrere Widerstände beliebig in Reihe oder parallel geschaltet werden, um zum einen beliebige Widerstandswerte außerhalb der gebräuchlichen Normwerte zu realisieren, und zum anderen durch Parallelschaltung die Zuleitungsinduktivität zu verringern. Weiterhin bietet sich an dieser Stelle im Hinblick auf Temperaturbeständigkeit ein Schaltungsaufbau auf Keramik- oder PTFE-Substrat an. An Stelle der diskreten Widerstände können außerdem die Schaltungselemente in Dickschicht- oder Dünnschichttechnik auf das Substrat aufgebracht werden.

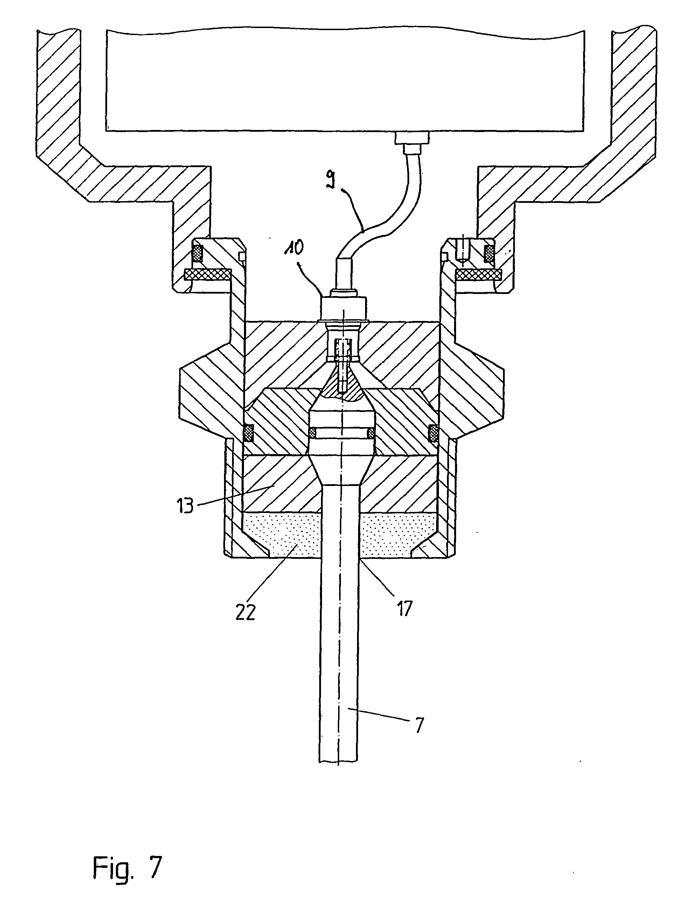

In der Fig. 7 ist eine alternative Form der verlustbehafteten Anpassung der Durchführung dargestellt. An Stelle des Widerstands von Fig. 6 ist hier eine wellendämpfende Schicht 22 vorgesehen, die direkt an die Verbindungsstelle 17 anschließt. Als Beispiele für Materialien, aus denen eine solche Schicht bestehen kann, seien hier eine Verteilung von Leitpigmenten in Teflon oder eine Verteilung von Graphitpulver in Teflon genannt. Durch Form, Dicke und Materialbeschaffenheit des wellendämpfenden Elements 22 lässt sich analog zur Auswahl des Anpasswiderstandswerts der günstigste Kompromiss zwischen Eliminierung des Störechos und Dämpfung des Nutzechos finden. Durch eine kegelige Form des Elements 22 beispielsweise lässt sich die Grenzfläche zum Isolierelement 13 so gestalten, dass dort ein für die Wellenausbreitung sanfter Übergang ohne zusätzliche Reflexionen entsteht.

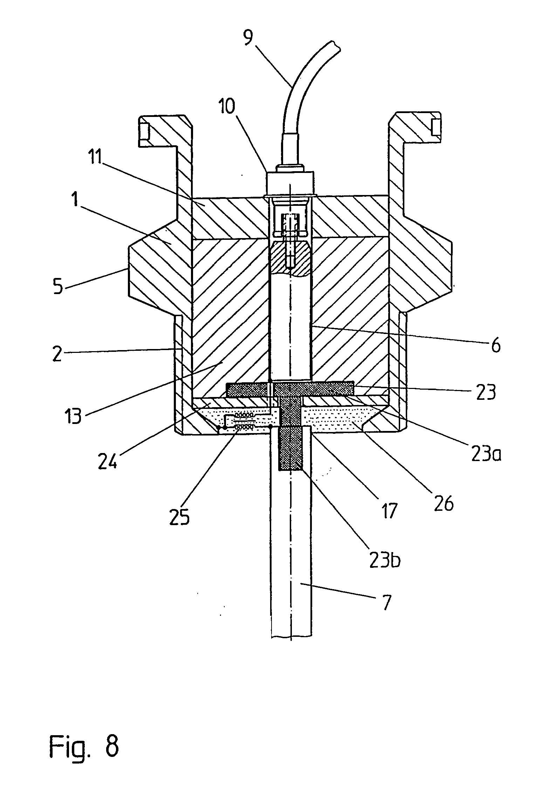

Ein weiteres Ausführungsbeispiel einer Anpassung mit Hochfrequenz-Übertrager ist in Fig. 8 dargestellt. Das Leitelement 6 bildet wieder zusammen mit dem Trägerelement 1 eine Koaxialleitung, die beispielsweise die Impedanz von Kabel 9 und Stecker 10 reflexionsfrei weiterführt. Der Einzelleiter 7 ragt nur ein kleines Stück über die Verbindungsstelle 17 hinaus in die Durchführung. Leitelement 6 und Einzelleiter 7 sind nicht direkt miteinander verbunden. Vielmehr ist ein isolierendes Halteelement 23, bestehend beispielsweise aus einer Scheibe 23a und einem Zapfen 23b, zwischen den beiden leitenden Elementen 6 und 7 eingebaut. Der mit einem Außengewinde versehene Zapfen 23b wird beispielsweise in ein Innengewinde des Einzelleiters 7 geschraubt. Das Halteelement 23 wird gestützt durch eine beispielsweise metallene Scheibe 24, die die Zugkräfte am Einzelleiter 7 auf das Trägerelement 1 überträgt. Zwischen dem Ende der aus Leitelement 6 und Trägerelement 1 gebildeten Koaxialleitung und dem Beginn des Einzelleiters 7 ist elektrisch ein Hochfrequenz-Übertrager 25 geschaltet. Sein Windungsverhältnis ist so bemessen, dass er die Impedanz des Einzelleiters 7 auf die Impedanz der durchführungsinternen Koaxialleitung transformiert, d.h. er transformiert z.B. 300Ω auf 50Ω, was einem Windungsverhältnis von ca. 1 : 2,45 entspricht. Zum Schutz des Übertragers 25 vor Einflüssen der Behälteratmosphäre ist er eingebettet in Vergussmaterial 26.

Die Fig. 9 schließlich zeigt ein Beispiel einer Kombination zweier zuvor beschriebenen grundsätzlichen Lösungen zur Verbesserung der Anpassung. Die Durchführungskonstruktion mit interner Paralleldrahtleitung nach Fig. 3 besitzt nun ein zusätzliches Element 27, das aus wellendämpfenden Material besteht und analog zur Scheibe 22 in Fig. 7 eine Impedanzanpasswirkung bei gleichzeitiger Reduzierung der Nutzsignalamplitude aufweist. Durch Variierung sowohl der Geometrie der Zweidrahtleitung als auch der Geometrie und Materialbeschaffenheit des Elements 27 sind in für den Fachmann offensichtlicher Weise die Wirkungen beider Anpassmaßnahmen so aufeinander abzustimmen, dass das Resultat möglichst nahe dem Ideal von geringstem Störecho und großem Nutzecho kommt.

Weitere Kombinationen verschiedener Elemente aus vorbeschriebenen Anpassmethoden sind ebenso möglich und für den Fachmann offensichtlich, ohne hier lückenlos aufgeführt zu sein. Beispielsweise ist die Zweidrahtlösung aus Fig. 3 kombinierbar mit der Widerstandsanpassung aus Fig. 6 oder die in Zusammenhang mit der Zweidrahtlösung erwähnte Ausgestaltung mit Übertrager auch anwendbar auf eine Lösung mit verlustbehafteter Anpassung.

## Patentansprüche

1. Durchführung für ein elektrisches Hochfrequenzsignal in einem TDR-Füllstandmessgerät mit
- einem Leitelement (6), in das an einer Einleitstelle (10) das elektrische Hochfrequenzsignal einzuspeisen ist und das an einer Ausleitstelle (17) das elektrische Hochfrequenzsignal an einer zur Führung des Hochfrequenz-Signals dienenden Sonde (7) überträgt, wobei es sich bei der Ausleitstelle um die Verbindungsstelle zwischen dem Leitelement (6) und der Sonde (7) handelt,
- einem mechanischen Trägerelement (1),
- einer zwischen dem Trägerelement (1) und dem Leitelement (6) vorhandenen Isolierung (13, 12), **gekennzeichnet durch**
ein Dämpfungselement (20, 22) zur Dämpfung einer elektromagnetischen Welle, das im Bereich der Ausleitstelle zwischen dem Trägerelement (1) und dem Leitelement (6) vorhanden ist und derart ausgestaltet ist, dass die Impedanz der Durchführung und die Impedanz der sich an der Ausleitstelle (17) anschließenden Sonde (7) an der Ausleitstelle (17) im Wesentlichen aneinander angeglichen sind.

2. Durchführung nach Anspruch 1,
**dadurch gekennzeichnet, dass** als Dämpfungselement ein diskreter ohmscher Widerstand (20) vorhanden ist, der derart gewählt ist, dass die resultierende Impedanz aus der Parallelschaltung der Impedanz der Sonde (7) und dem Widerstand (20) an der Ausleitstelle (17) im Wesentlichen an die Impedanz der von dem Leitelement (6) und dem Trägerelement (1) gebildeten koaxialen Leitung angeglichen ist.

3. Durchführung nach Anspruch 2,
**dadurch gekennzeichnet, dass** der ohmsche Widerstand (20) im Bereich der Ausleitstelle (17) zwischen dem Trägerelement (1) und dem Leitelement (6) vorhanden ist.

4. Durchführung nach Anspruch 2 oder 3,
**dadurch gekennzeichnet, dass** der ohmsche Widerstand (20) in einer Vergussmasse eingebettet ist.

5. Durchführung nach Anspruch 1,
**dadurch gekennzeichnet, dass** als Dämpfungselement ein wellendämpfendes Material (22) in der Nähe der Ausleitstelle (17) innerhalb der Durchführung angeordnet ist.

6. Durchführung nach Anspruch 5,
**dadurch gekennzeichnet, dass** das wellendämpfende Material (22) eine Mischung aus leitfähigen Pigmenten eingebettet in ein isolierendes Füllmaterial ist.

7. Durchführung nach einem der Ansprüche 5 oder 6,
**dadurch gekennzeichnet, dass** das wellendämpfende Material (22) den Zwischenraum zwischen dem Leitelement (6) und dem Trägerelement (1) zumindest teilweise ausfüllt.

8. Durchführung nach einem der Ansprüche 5-7,
**dadurch gekennzeichnet, dass** das wellendämpfende Material (22) eine im wesentlichen zylindrische Form aufweist.

9. Durchführung nach einem der Ansprüche 5-7,
**dadurch gekennzeichnet, dass** das wellendämpfende Material (22) eine weitgehend kegelförmige Form aufweist.

10. Durchführung nach einem der voranstehenden Ansprüche,
**dadurch gekennzeichnet, dass** zusätzlich ein Hochfrequenz-Übertrager (25) vorhanden ist, der im Bereich der Ausleitstelle (17) das Trägerelement (1) und das Leitelement (6) miteinander elektrisch verbindet und die Impedanzen im wesentlichen aneinander angleicht.

11. Durchführung nach Anspruch 10,
**dadurch gekennzeichnet, dass** der Hochfrequenz-Übertrager (25) in isolierendes und schützendes Vergussmaterial eingebettet ist.

12. Durchführung nach Anspruch 10 oder 11,
**dadurch gekennzeichnet, dass** der Hochfrequenz-Übertrager (25) die Impedanz des durchführungsinternen Leitelementes (6) zumindest teilweise auf die Impedanz der Sonde (7) transformiert.

13. Durchführung nach einem der voranstehenden Ansprüche,
**dadurch gekennzeichnet, dass** zumindest ein zusätzliches Leitelement (18) vorhanden ist, das auf den Bereich der Durchführung begrenzt ist.

14. Durchführung nach Anspruch 13,
**dadurch gekennzeichnet dass** das zusätzliche Leitelement (18) mit dem Trägerelement (1) elektrisch leitend verbunden ist.

15. Durchführung nach Anspruch 13 oder 14,
**dadurch gekennzeichnet dass** sich der Abstand und das Durchmesserverhältnis der beiden Leitelemente (6, 18) zumindest auf einer Teillänge der Durchführung ändern.

16. Durchführung nach Anspruch 15,
**dadurch gekennzeichnet dass** sich der Abstand und das Durchmesserverhältnis der beiden Leitelemente (6, 18) zumindest auf einer Teillänge der Durchführung kontinuierlich ändern.

17. Durchführung nach einem der Ansprüche 14-16,
**dadurch gekennzeichnet dass** das zusätzliche Leitelement (18) am Ende (18c) mit dem Trägerelement (1) verbunden ist.

18. Durchführung nach einem der Ansprüche 14-17,
**dadurch gekennzeichnet dass** das zusätzliche Leitelement (18) am Ende (18c) über einen Widerstand mit dem Trägerelement (1) verbunden ist.

19. Durchführung nach Anspruch 1,
**dadurch gekennzeichnet, dass** die Impedanz an der Ausleitstelle (17) zur Angleichung an die Impedanz der sich an die Ausleitstelle (17) anschließenden Sonde (7) wesentlich höher ist als die Impedanz an der Einleitstelle (10).

20. Durchführung nach einem der voranstehenden Ansprüche,
**dadurch gekennzeichnet, dass** das Leitelement (6) koaxial zum Trägerelement (1) angeordnet ist.

21. Durchführung nach Anspruch 1,
**dadurch gekennzeichnet, dass** sich die Impedanz von der Einleitstelle (10) zur Ausleitstelle (17) kontinuierlich ändert.

22. Durchführung nach Anspruch 1,
**dadurch gekennzeichnet, dass** sich die Impedanz von der Einleitstelle (10) zur Ausleitstelle (17) gestuft ändert.

23. Durchführung nach Anspruch 1,
**dadurch gekennzeichnet, dass** sich der Innendurchmesser des Trägerelements (1) von der Einleitstelle (10) zur Ausleitstelle (17) verändert.

24. Durchführung nach Anspruch 1,
**dadurch gekennzeichnet, dass** sich der Außendurchmesser des Leitelements (6) von der Einleitstelle (10) zur Ausleitstelle (17) verringert.

25. Durchführung nach Anspruch 17,
**dadurch gekennzeichnet, dass** das Leitelement (6) zumindest abschnittsweise eine kegelförmige Form besitzt.

26. Durchführung nach Anspruch 1,
**dadurch gekennzeichnet, dass** das Trägerelement (1) zumindest abschnittsweise eine konische Innenkontur besitzt.

27. Durchführung nach einem der voranstehenden Ansprüche,
**dadurch gekennzeichnet, dass** sich die Dielektrizitätskonstante der Isolierung (12, 13) von der Einleitstelle (10) zur Ausleitstelle (17) verändert.

28. Füllstandmessvorrichtung zur Messung des Füllstands über die Laufzeitmessung einer geführten elektromagnetischen Welle, mit einer Elektronikeinheit (8) zur Erzeugung der elektromagnetischen Welle und zur Auswertung empfangener Echosignale und einer mit der Elektronikeinheit (8) verbundenen Hochfrequenz-Durchführung nach einem oder mehreren der voranstehenden Ansprüche.

## Claims

1. A leadthrough for an electrical high-frequency signal in a TDR fill-level measuring device with
- a guide element (6) into which at a feed-in location (10) the electrical high-frequency signal is to be fed in, and which at a feed-out location (17) transmits the electrical high-frequency signal to a probe (7) that is used to guide the high-frequency signal, wherein the feed-out location is the junction between the guide element (6) and the probe (7),
- a mechanical supporting element (1),
- an insulation (13, 12) that is present between the supporting element (1) and the guide element (6), **characterised by**
an attenuation element (20, 22) for attenuating an electromagnetic wave, which attenuation element (20, 22) is present in the region of the feed-out location between the supporting element (1) and the guide element (6) and is designed in such a manner that the impedance of the leadthrough and the impedance of the probe (7) that follows on from the feed-out location (17) at the feed-out location (17) are essentially approximated to each other.

2. The leadthrough according to claim 1, **characterised in that** as an attenuation element a discrete ohmic resistor (20) is present that has been selected in such a manner that the resulting impedance from parallel connection of the impedance of the probe (7) and the resistor (20) at the feed-out location (17) is essentially approximated to the impedance of the coaxial line formed by the guide element (6) and the supporting element (1).

3. The leadthrough according to claim 2, **characterised in that** the ohmic resistor (20) is located in the region of the feed-out location (17) between the supporting element (1) and the guide element (6).

4. The leadthrough according to claim 2 or 3, **characterised in that** the ohmic resistor (20) is embedded in a casting compound.

5. The leadthrough according to claim 1, **characterised in that** as an attenuation element a wave-attenuating material (22) is arranged near the feed-out location (17) within the leadthrough.

6. The leadthrough according to claim 5, **characterised in that** the wave-attenuating material (22) is a mixture of conductive pigments embedded in an insulating filling material.

7. The leadthrough according to one of claims 5 or 6, **characterised in that** the wave-attenuating material (22) at least to some extent fills in the space between the guide element (6) and the supporting element (1).

8. The leadthrough according to any one of claims 5-7, **characterised in that** the wave-attenuating material (22) comprises an essentially cylindrical shape.

9. The leadthrough according to any one of claims 5-7, **characterised in that** the wave-attenuating material (22) comprises a largely conical shape.

10. The leadthrough according to any one of the preceding claims, **characterised in that** in addition there is a high-frequency transmitter (25) which in the region of the feed-out location (17) electrically interconnects the supporting element (1) with the guide element (6) and essentially approximates the impedances to each other.

11. The leadthrough according to claim 10, **characterised in that** the high-frequency transmitter (25) is embedded in insulating and protective casting material.

12. The leadthrough according to claim 10 or 11, **characterised in that** the high-frequency transmitter (25) transforms the impedance of the leadthrough-internal guide element (6) at least in part to the impedance of the probe (7).

13. The leadthrough according to any one of the preceding claims, **characterised in that** there is at least one additional guide element (18) that is limited to the region of the leadthrough.

14. The leadthrough according to claim 13, **characterised in that** the additional guide element (18) is connected to the supporting element (1) in an electrically conductive manner.

15. The leadthrough according to claim 13 or 14, **characterised in that** the distance and the diameter ratio of the two guide elements (6, 18) change at least on a partial length of the leadthrough.

16. The leadthrough according to claim 15, **characterised in that** the distance and the diameter ratio of the two guide elements (6, 18) continuously change at least on a partial length of the leadthrough.

17. The leadthrough according to any one of claims 14-16, **characterised in that** the additional guide element (18) at the end (18c) is connected to the supporting element (1).

18. The leadthrough according to any one of claims 14-17, **characterised in that** the additional guide element (18) at the end (18c) is connected to the supporting element (1) by way of a resistor.

19. The leadthrough according to claim 1, **characterised in that** the impedance at the feed-out location (17) for the purpose of approximation to the impedance of the probe (7) that follows on from the feed-out location (17) is significantly higher than the impedance at the feed-in location (10).

20. The leadthrough according to any one of the preceding claims, **characterised in that** the guide element (6) is arranged so as to be coaxial with the supporting element (1).

21. The leadthrough according to claim 1, **characterised in that** the impedance from the feed-in location (10) to the feed-out location (17) continuously changes.

22. The leadthrough according to claim 1, **characterised in that** the impedance from the feed-in location (10) to the feed-out location (17) changes in a stepped manner.

23. The leadthrough according to claim 1, **characterised in that** the internal diameter of the supporting element (1) changes from the feed-in location (10) to the feed-out location (17).

24. The leadthrough according to claim 1, **characterised in that** the external diameter of the guide element (6) changes from the feed-in location (10) to the feed-out location (17).

25. The leadthrough according to claim 17, **characterised in that** the guide element (6) at least in a section comprises a conical shape.

26. The leadthrough according to claim 1, **characterised in that** the supporting element (1) at least in some sections comprises a conical internal contour.

27. The leadthrough according to any one of the preceding claims, **characterised in that** the relative permittivity of the insulation device (12, 13) changes from the feed-in location (10) to the feed-out location (17).

28. A fill-level measuring device for measuring the fill level by way of transit-time measuring of a guided electromagnetic wave, with an electronics unit (8) for generating the electromagnetic wave and for evaluating received echo signals, and with a high-frequency leadthrough, which is connected to the electronics unit (8), according to any one or several of the preceding claims.

## Revendications

1. Traversée pour un signal électrique à haute fréquence dans un appareil de mesure de niveau TDR, comprenant
- un élément conducteur (6), dans lequel peut être injecté le signal électrique à haute fréquence en un point d'entrée (10) et qui transmet en un point de sortie (17) le signal électrique à haute fréquence à une sonde (7) servant au guidage de ce dernier, le point de sortie étant le point de jonction entre l'élément conducteur (6) et la sonde (7),
- un élément support mécanique (1),
- une isolation (13, 12) entre l'élément support (1) et l'élément conducteur (6),
**caractérisée par** un élément d'atténuation (20, 22) pour l'affaiblissement d'une onde électromagnétique, lequel élément est prévu dans la zone du point de sortie entre l'élément support (1) et l'élément conducteur (6) et est configuré de telle sorte que l'impédance de la traversée et l'impédance de la sonde (7), se raccordant au point de sortie (17), sont essentiellement adaptées entre elles au point de sortie (17).

2. Traversée suivant la revendication 1, **caractérisée en ce qu'**une résistance ohmique discrète (20) est prévue en tant qu'élément d'atténuation, laquelle résistance est choisie de telle sorte que l'impédance résultante du montage en parallèle de l'impédance de la sonde (7) et de la résistance (20) est essentiellement adaptée, au point de sortie (17), à l'impédance de la ligne coaxiale formée par l'élément conducteur (6) et l'élément support (1).

3. Traversée suivant la revendication 2, **caractérisée en ce que** la résistance ohmique (20) est prévue dans la zone du point de sortie (17) entre l'élément support (1) et l'élément conducteur (6).

4. Traversée suivant l'une des revendications 2 et 3, **caractérisée en ce que** la résistance ohmique (20) est enrobée dans une masse de scellement.

5. Traversée suivant la revendication 1, **caractérisée en ce qu'**un matériau d'affaiblissement caractéristique (22) est disposé en tant qu'élément d'atténuation à l'intérieur de la traversée, au voisinage du point de sortie (17).

6. Traversée suivant la revendication 5, **caractérisée en ce que** le matériau d'affaiblissement caractéristique (22) est un mélange de pigments conducteurs enrobés dans un matériau de remplissage isolant.

7. Traversée suivant l'une des revendications 5 ou 6, **caractérisée en ce que** le matériau d'affaiblissement caractéristique (22) remplit, au moins en partie, l'espace intermédiaire entre l'élément conducteur (6) et l'élément support (1).

8. Traversée suivant l'une des revendications 5 à 7, **caractérisée en ce que** le matériau d'affaiblissement caractéristique (22) présente une forme essentiellement cylindrique.

9. Traversée suivant l'une des revendications 5 à 7, **caractérisée en ce que** le matériau d'affaiblissement caractéristique (22) présente une forme largement conique.

10. Traversée suivant l'une des revendications précédentes, **caractérisée en ce qu'**il est prévu en supplément un transformateur à haute fréquence (25), qui relie électriquement entre eux, dans la zone du point de sortie (17), l'élément support (1) et l'élément conducteur (6) et adapte essentiellement entre elles les impédances.

11. Traversée suivant la revendication 10, **caractérisée en ce que** le transformateur à haute fréquence (25) est enrobé dans une masse de scellement isolante et protectrice.

12. Traversée suivant l'une des revendications 10 ou 11, **caractérisée en ce que** le transformateur à haute fréquence (25) transforme, au moins en partie, l'impédance de l'élément conducteur (6) interne à la traversée à l'impédance de la sonde (7).

13. Traversée suivant l'une des revendications précédentes, **caractérisée en ce qu'**il est prévu au moins un élément conducteur supplémentaire (18), limité à la zone de la traversée.

14. Traversée suivant la revendication 13, **caractérisée en ce que** l'élément conducteur supplémentaire (18) est relié en conduction électrique à l'élément support (1).

15. Traversée suivant l'une des revendications 13 et 14, **caractérisée en ce que** l'écartement et le rapport diamétral des deux éléments conducteurs (6, 18) se modifient au moins sur une longueur partielle de la traversée.

16. Traversée suivant la revendication 15, **caractérisée en ce que** l'écartement et le rapport diamétral des deux éléments conducteurs (6, 18) se modifient en continu au moins sur une longueur partielle de la traversée.

17. Traversée suivant l'une des revendications 14 à 16, **caractérisée en ce que** l'élément conducteur supplémentaire (18) est relié sur son extrémité (18c) à l'élément support (1).

18. Traversée suivant l'une des revendications 14 à 17, **caractérisée en ce que** l'élément conducteur supplémentaire (18) est relié sur son extrémité (18c) à l'élément support (1) par l'intermédiaire d'une résistance.

19. Traversée suivant la revendication 1, **caractérisée en ce que** l'impédance au point de sortie (17), pour l'adaptation à l'impédance de la sonde (7) se raccordant au point de sortie (17), est essentiellement plus élevée que l'impédance au point d'entrée (10).

20. Traversée suivant l'une des revendications précédentes, **caractérisée en ce que** l'élément conducteur (6) a une disposition coaxiale à l'élément support (1).

21. Traversée suivant la revendication 1, **caractérisée en ce que** l'impédance se modifie en continu du point d'entrée (10) au point de sortie (17).

22. Traversée suivant la revendication 1, **caractérisée en ce que** l'impédance se modifie graduellement du point d'entrée (10) au point de sortie (17).

23. Traversée suivant la revendication 1, **caractérisée en ce que** le diamètre intérieur de l'élément support (1) se modifie du point d'entrée (10) en direction du point de sortie (17).

24. Traversée suivant la revendication 1, **caractérisée en ce que** le diamètre extérieur de l'élément conducteur (6) se réduit du point d'entrée (10) en direction du point de sortie (17).

25. Traversée suivant la revendication 17, **caractérisée en ce que** l'élément conducteur (6) présente, au moins par sections, une forme conique.

26. Traversée suivant la revendication 1, **caractérisée en ce que** l'élément support (1) présente, au moins par sections, un contour intérieur conique.

27. Traversée suivant l'une des revendications précédentes, **caractérisée en ce que** la permittivité de l'isolation (12, 13) se modifie du point d'entrée (10) au point de sortie (17).

28. Dispositif de mesure de niveau destiné à la mesure du niveau par l'intermédiaire de la mesure du temps de parcours d'une onde électromagnétique guidée, comprenant une unité électronique (8) pour générer l'onde électromagnétique et évaluer les signaux d'écho reçus et une traversée à haute fréquence, reliée à l'unité électronique (8), suivant l'une ou plusieurs des revendications précédentes.
